# EUROPEAN PATENT SPECIFICATION

(11) **EP 0 634 785 B1**
(45) Date of publication and mention of the grant of the patent: **23.07.1997**
(21) Application number: 94304866.0
(22) Date of filing: 01.07.1994
(51) Int. Cl.: H01L 21/00

(54) **Improved susceptor design**
Verbesserte Suszeptor Ausführung
Suscepteur de conception améliorée

(30) Priority: 13.07.1993 US 90591
(43) Date of publication of application: 18.01.1995
(73) Proprietor: APPLIED MATERIALS, INC., Santa Clara, California 95054-3299 (US)
(72) Inventor: Beinglass, Israel, Sunnyvale, CA 94087 (US)
(74) Representative: Bayliss, Geoffrey Cyril

(56) References cited:
- EP-A- 0 467 624
- EP-A- 0 513 834
- US-A- 4 473 455
- US-A- 4 817 558
- US-A- 4 951 602

## Description

This invention relates to an improved method and apparatus for depositing polysilicon onto silicon substrates. More particularly, this invention relates to a single substrate processing chamber for depositing a polysilicon layer having improved uniformity onto semiconductor substrates and method therefor.

Doped or undoped silicon layers have been deposited onto silicon substrates, such as silicon wafers, using a low pressure chemical vapor deposition (CVD) process. A reaction gas mixture including a source of silicon, such as silane, disilane, silicon tetrachloride and the like, and optionally a dopant gas such as phosphine, arsine, diborane and the like, and optionally including a carrier gas (such as hydrogen, argon, nitrogen or helium), is heated and passed over a silicon substrate to deposit a silicon film on the surface of the substrate. The exact crystallographic nature of the deposited silicon depends upon the temperature of deposition. At low reaction temperatures, the deposited silicon is mostly amorphous; when higher deposition temperatures are employed, a mixture of amorphous silicon and polysilicon or polysilicon alone will be deposited.

The prior art methods use comparatively low pressures of about 26.7 to 53.3 Pa (200-400 millitorr) for this process. Good quality films can be formed, but very low deposition rates of about 100 angstroms/min for undoped, and about 30 angstroms/min for doped, polysilicon are obtained. This low deposition rate can be overcome by processing a plurality of wafers, i.e., up to 100, at once in a batch-type processing chamber.

However, present day thin film equipment for the semiconductor industry has been moving toward single substrate processing, because the processing chambers can be made smaller and processing can be better controlled. Further, modern semiconductor vacuum processing systems have been developed to carry out more than one processing step on a substrate without removing the substrate from a vacuum environment. The use of such vacuum systems results in a reduced number of particulates that contaminate the surface of the wafers during processing, thereby improving the device yield. Such vacuum systems include a central robotic transfer chamber connected to various processing chambers, such as the Applied Materials 5000 series processing system described in US Patent 4,951,601 to Maydan et al.

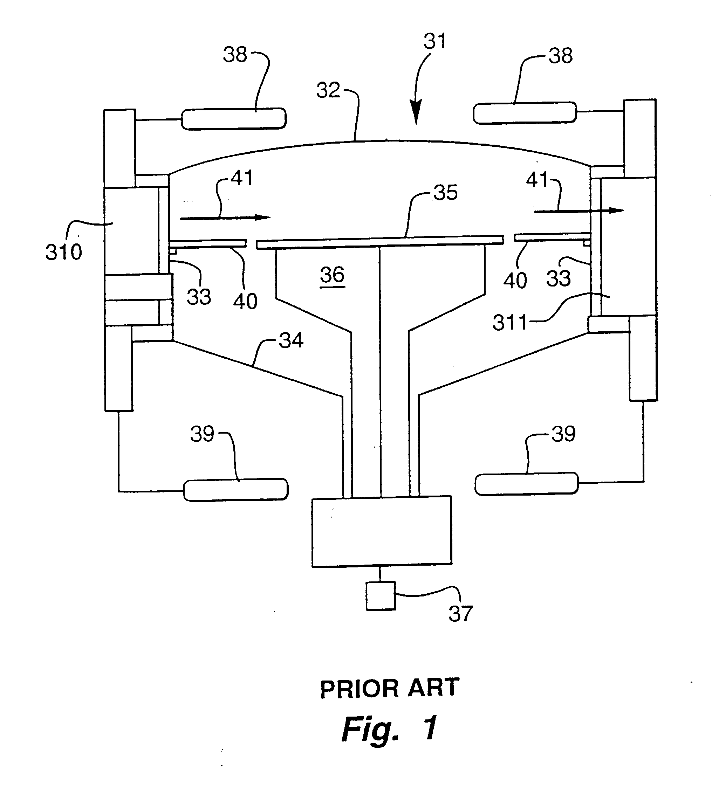

Thus CVD equipment for single substrate processing to deposit polysilicon onto semiconductor substrates are coming into commercial use. A CVD chamber for such purpose has been described heretofore and will be described with reference to Fig. 1.

Referring to Fig. 1, a single substrate reactor 31 has a top wall 32, side walls 33 and a bottom wall 34 that define the reactor 31 into which a single substrate 35, such as a silicon wafer, can be loaded. The substrate 35 is mounted on a pedestal or susceptor 36 that is rotated by a motor 37 to provide a time averaged environment for the substrate 35 that is cylindrically symmetric. A preheat ring 40 is supported in the chamber 30 and surrounds the wafer 35. The wafer 35 and the preheat ring 40 are heated by light from a plurality of high intensity lamps 38 and 39 mounted outside of the reactor 31. The top wall 32 and the bottom wall 34 of the chamber 30 are substantially transparent to light to enable the light from the external lamps 38 and 39 to enter the reactor 31 and heat the susceptor 36, the substrate 35 and the preheat ring 40. Quartz is a useful material for the top wall 32 and the bottom wall 34 because it is transparent to light of visible and IR frequencies; it is a relatively high strength material that can support a large pressure difference across these walls; and because it has a low rate of outgassing.

During deposition, the reactant gas stream flows from a gas input port 310, across the preheat ring 40 where the gases are heated, across the surface of the substrate 35 in the direction of the arrows 41 to deposit silicon films thereon, and into an exhaust port 311. The gas input port 310 is connected to a gas manifold (not shown) that provides one or a mixture of gases to enter the reactor 31 via a plurality of pipes into this port. The locations of the input ends of these pipes, the gas concentrations and/or flow rate through each of these pipes are selected to produce reactant gas flows and concentration profiles that optimize processing uniformity. Although the rotation of the substrate and thermal gradients caused by the heat from the lamps 38 and 39 can significantly affect the flow profile of the gases in the reactor 31, the dominant shape of the flow profile is a laminar flow from the gas input port 310 and across the preheat ring 40 and the substrate 35 to the exhaust port 311.

In a typical process producing an undoped silicon layer on a silicon wafer, a pressure of between 133 Pa to 26.7kPa (1-200 Torr) is maintained in the chamber by feeding hydrogen at about 4-10 liters/min into the chamber and adding about 200-500 cm³ of silane at a temperature of the substrate of about 560-750°C, as determined by a suitable pyrometer. A polysilicon film can be deposited under these conditions at a rate of about 2000 angstroms/min. The higher pressures used in the above method improves the rate of deposition of doped or undoped polysilicon.

A disadvantage with the above processing reactor is that it has been found that unwanted deposition of silicon occurs on the backside of both the wafer and the susceptor. Deposition on the backside of the wafer is unacceptable from a quality control point of view while deposition on the backside of the susceptor can, as is described below, adversely effect the necessary wafer temperature measurements.

EP-A-0467624 discloses a CVD reactor in which a inert thermal gas such as argon is introduced onto the backside of wafers being processed during the deposition of tungsten or other metals and silicides to avoid deposition of material on the backside of the wafers being processed. Each process station includes a gas dispersion head disposed over a platen. The platen has a circular depression for receiving a wafer and an annular groove provided in the floor of the depression near the wall thereof. Heated and pressurised backside gas is introduced into the groove so that the wafer is maintained in a position above the floor of the depression but still within it. In this manner, backside gas vents from beneath the edge of the wafer on the platen and prevents the process gases from contacting the wafer backside.

US-A-4817558 discloses a thin-film depositing apparatus which includes a reaction chamber containing a substrate supporting member to receive a substrate on which a thin film is to be deposited. A cover member covers the whole surface of the substrate supporting member except a substrate bearing surface on which the substrate is to be set. The surface temperature of the cover is kept lower than that of the substrate so that any undesired film is restrained from being deposited on the surface of the cover member.

Generally the groove lies beyond the perimeter of the substrate.

The susceptor may further include a stepped formation, formed at its perimeter. The stepped formation interfaces with a complemental stepped formation formed in a susceptor circumscribing preheat ring located in the chamber and operates to restrict substrate processing gas from reaching the rear surface of the susceptor.

The following is a description of some specific embodiments of the invention, reference being made to the accompanying drawings, in which:

Fig. 1 is a cross sectional partially schematic view of a single substrate deposition chamber of the prior art;

Accordingly, it is desirable to provide a substrate processing apparatus that overcomes or minimizes deposition on the backside of the wafer whilst avoiding the complications of the prior art indicated above.

This invention provides an apparatus for chemically processing a substrate comprising a housing including a substrate processing chamber, a gas inlet port for injecting chemical processing gas into the chamber, a gas outlet port for evacuation of gases from the chamber and a susceptor support for a substrate to be processed having a substrate support surface and a backside surface opposite to said support surface, said substrate support surface having a pocket therein for the reception of the substrate, the pocket having a floor and generally upright sides and being sized to receive the substrate therein, the floor of the pocket having a circumscribing groove dimensioned so that, when the substrate is received in the pocket, the groove lies at the perimeter of the substrate; wherein a preheat ring is provided adjacent to and surrounding said susceptor support, the susceptor support has an extension between the support surface and the backside surface, and said preheat ring has an extension that mates with the susceptor support extension forming a barrier to prevent said processing gas from reaching the backside surface of the susceptor, said groove in the floor of the pocket providing a receptacle for deposited material to reduce the amount of material that is deposited on the backside of the substrate.

The invention also provides a susceptor for use in a substrate processing apparatus including a substrate processing chamber for housing the susceptor, the susceptor comprising a front, substrate receiving surface and a rear surface, a substrate receiving pocket formed in the front surface, the pocket having a floor and generally upright sides being sized to receive a substrate therein, and a groove about the periphery and formed into the floor of said pocket and being dimensioned so that, when the substrate is received in the pocket, the groove lies at the perimeter of the substrate; wherein a preheat ring is provided adjacent to and surrounding said susceptor support, the susceptor support has an extension between the support surface and the backside surface, and said preheat ring has an extension that mates with the susceptor support extension forming a barrier so that processing gas does not deposit on the backside of the susceptor.
Fig. 2 is a cross sectional partially schematic view of a single substrate deposition chamber illustrating an embodiment of the present invention;
Fig. 3 is a cross sectional view of a one embodiment of a reactant gas barrier of the invention;
Fig. 4 is a partially sectioned pictorial view of a susceptor illustrating a further embodiment of this invention; and
Fig. 5 is a cross-section through the edge of a susceptor illustrating yet another embodiment of this invention.

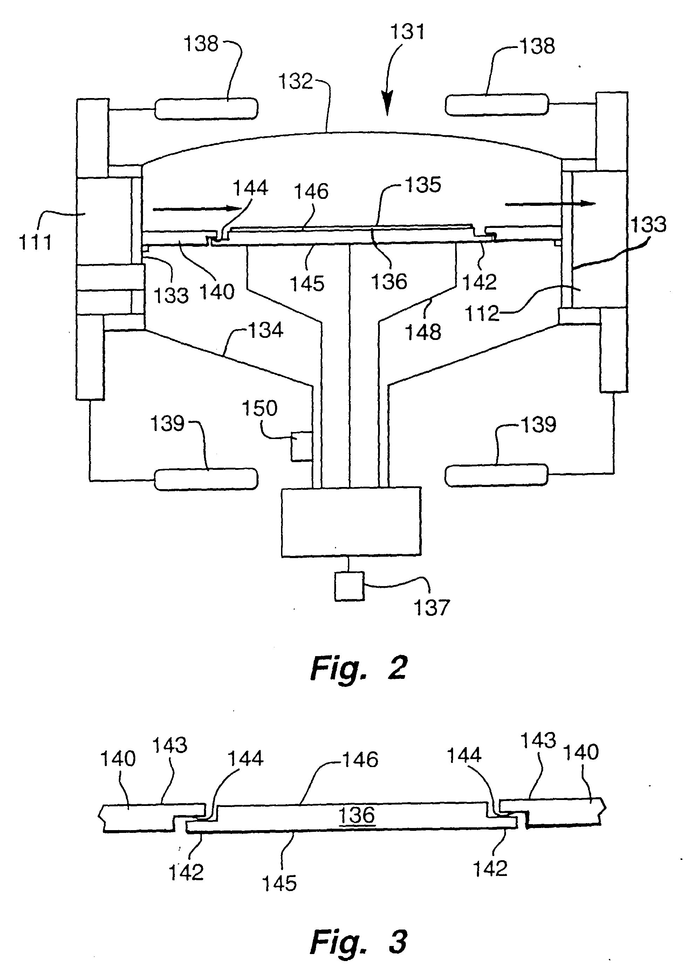

In Fig. 2, one embodiment of the improved susceptor of the invention is illustrated. This embodiment illustrates features which reduce the amount of deposition on the back side of the susceptor and shows a single substrate reactor 131 having a top wall 132, side walls 133 and a bottom wall 134. The top wall 132 and the bottom wall 134 are made of quartz. Outside of the reactor 131 are a plurality of high intensity lamps 138 and 139 which heat the preheat ring 140, a susceptor 136 and a substrate 135 on which a polysilicon film is to be deposited. The susceptor 136 is a flat plate having an upper surface 146 and a backside surface 145. A susceptor support 148 supports the susceptor 136. A reactant gas input port 111 and an exhaust port 112, situated in opposite sidewalls 133, ensure a laminar gas flow across the preheat ring 140 and the substrate 135.

As shown in greater detail in Fig 3, the susceptor has a stepped formation 142 formed at its perimeter. The stepped formation can either be formed in the body of the susceptor 136 or be defined by an extension mounted onto the susceptor. The preheat ring 140 has a complemental stepped formation 144 that mates with the stepped formation of the susceptor.

This configuration defines a tortuous path along which the processing gas must flow before it reaches the rear surface of the susceptor 136. This tortuous path both increases the distance that the gas has to move before it reaches the backside of the susceptor and causes turbulence in the gas flowing along the path. As a result deposition occurs on both halves of the overlapping formation defined by the complemented stepped formations in the susceptor and preheat ring 140 respectively. This reduces the amount of gas able to pass between the susceptor and the preheat ring and as a result, has been found to reduce the amount of deposition on the backside 145 of the susceptor.

It is believed that deposits of doped or undoped silicon or other solid materials onto the backside of the susceptor cause temperature variations across the susceptor 136. These temperature variations, in turn, cause variations, from wafer to wafer, in film thickness and properties of the deposited polysilicon films.

Further, a buildup of material on the backside 145 of the susceptor 136 causes incorrect temperature readings of the substrate 135 during deposition, also affecting the nature and deposition rate of the depositing films. The temperature of the susceptor 136 is determined by means of a pyrometer 150 which is mounted on the outside of the chamber 131 and above the lamps 139. The pyrometer 150 is sensitive to the emissivity of the backside surface 145 of the susceptor 136. If the emissivity of the backside surface 145 of the susceptor 136 changes due to deposition of various materials thereon, the pyrometer 150 obtains a varying signal and thus gives an erroneous temperature reading. Thus the emissivity of the backside surface 145 of the susceptor 136 must be kept as constant as possible.

Still further, as the buildup of material on the backside surface 145 continues during sequential substrate processing, a wafer-to-wafer variation in the deposited films also occurs, a variation which ideally should be kept as small as possible.

By restricting the reactant gases from reaching the backside of the susceptor deposition thereon is reduced. Thus temperature variations across the substrate, and on the susceptor, are reduced, and temperature readings of the substrate during deposition are more accurate than in prior art deposition chambers.

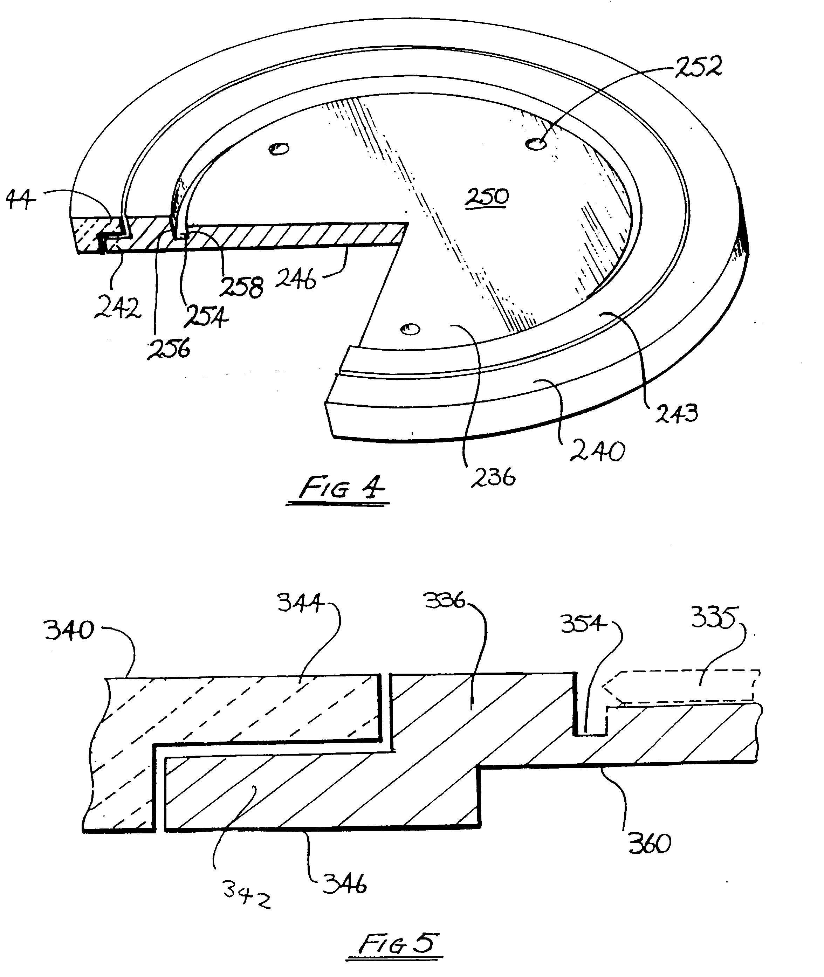

Fig. 4 illustrates another embodiment of this invention. In this figure the susceptor 236 is shown to include a stepped formation 242 similar to the stepped formation 142 illustrated in Figs. 2 and 3. Similarly, the preheat ring 240 has a complimental formation 244 which overlaps the stepped formation 242 of the susceptor 236. This formation 244 is similar to the formation 144 in the previous two figures.

In addition to this feature, the susceptor 236 also includes a sunken wafer receiving pocket 250. In the floor of the pocket, three circular holes 252 are shown. These holes 252 extend through the body of the susceptor 236 and act as guides for wafer lift fingers (not shown) which, during the transfer of the wafer to or from the susceptor, move relative to the susceptor to lift the wafer out of the pocket 250 and clear of the upper surface 243 of the susceptor.

Typically, the pocket 250 is formed to a level of approximately 1,02mm (0.04 inches) below the upper surface 243 of the susceptor 236. This depth is, however, variable and is determined by the thickness of the semiconductor wafer supported in the pocket. Ideally the top of the semiconductor wafer should be level with the upper surface 243 of the susceptor 236.

Also shown in this figure is an annular groove 254 which is formed about the periphery of the wafer receiving pocket 250. The groove 254 is approximately 2,03mm (0.08 inches) wide and has its bottom surface 4,45mm (0.175 inches) below the level of the pocket 250. The groove 254 is dimensioned so that, when a wafer is supported in the pocket 250, the groove circumscribes the outer edge of the wafer, i.e., the diameter of the wafer is less than the diameter of the inner wall 258 of the groove 254.

In prior art susceptors, none of which included the annular groove, it has been found that a certain amount of processing gas seeps in underneath the semiconductor wafer supported on such susceptor and causes deposition on the backside of the wafer. This deposition can be so severe that it extends towards the center of the wafer by as much as up to 25,4mm (1 inch) from the outer periphery of the wafer. Because of subsequent processing steps, this backside deposition is, for certain applications, unacceptable from a quality control point of view.

The sunken pocket 250 and, more particularly, the groove 254 of the susceptor 236 illustrated in this figure overcome this problem.

Firstly, when the wafer is located in the pocket 250 its upper surface is generally at the same level as the upper surface 243 of the susceptor 236. As a result, the reactant gases flowing across the upper surface of the wafer are prevented, to some degree, from seeping in underneath the wafer by the outer wall 256 of the groove 254.

Secondly and more importantly, if reactant gas moves into the space between the wafer's outer edge and the outer wall 256, this gas first moves down into the bottom of the groove and then up along its inner wall 258 before it moves under the wafer resting in the pocket 250.

This effect could be as a result of a number of factors. The reactant gases have a laminar flow on entering the chamber but when these gases flow into the groove a certain amount of turbulence is created in the gas. As a result, the gas does not have the necessary directional flow to seep in underneath the wafer. Furthermore, at the typical temperatures that the wafer processing reactors operate at, the reactant gases only react when they come into contact with a heated surface. As a result of the configuration illustrated above the path length (i.e., the heated surface area) that the gas comes into contact with before it reaches the wafer, is substantially increased.

The effect of both of these and other factors is that most of the deposition of reactant product occurs along the interior walls of the groove and not on the backside of the wafer. It has been found that this is so successful that the amount of deposition on the wafer's backside has been reduced from about 25,4mm (1 inch) to somewhere in the region of 2-3mm.

In Fig. 5 yet another improvement to the susceptor is shown. In this figure components similar to those in the previous figures have been given similar reference numerals. So, for example, susceptor 236 (Fig. 4) is referenced as 336 in this figure. As the various elements in this figure that are common with Fig. 4 have already been described, no further description of these elements will be necessary. What this figure does, however, show is a wafer 335 (shown in broken lines), located in the pocket 350. This wafer 335 is shown merely to illustrate approximately how it is received in the pocket 350.

In addition, the susceptor 336 shown in this figure has, instead of a uniformly uninterrupted underside 346, a circular pocket 360 formed in it from below. This pocket 360 has the effect that the thermal mass of the entire susceptor 336 is reduced. As a result, the amount of heat retained by the susceptor 336 is less than it would be if the pocket 360 had not been formed in the underside 346.

This is particularly advantageous in certain processing operations where the temperature is ramped up and down very quickly and the susceptor needs to warm up or cool down rapidly. A reduction in the thermal mass of the susceptor, as provided for in this embodiment, makes this increase and decrease in temperatures easier.

The processing chamber of the invention and the described improvements to the susceptor can be employed alone or, preferably, can be part of a multi-chamber vacuum processing system as described above. In that case the processing chamber of the invention has a port in a sidewall thereof for transferring substrates into and out of the chamber from a central transfer chamber.

One advantage of this invention is that a barrier to the flow of reactant gases to the backside of the susceptor is provided. This prevents deposits on the backside of the susceptor and resultant temperature measurement inaccuracies. Accordingly, wafer-to-wafer variations in film thickness are prevented or minimized.

Another advantage of this invention is that processing gases are prevented from seeping in underneath the wafer. This substantially reduces the occurrence of deposition on the wafer backside and thereby improves the quality of the wafer.

## Claims

1. An apparatus for chemically processing a substrate comprising:
a) a housing including a substrate processing chamber (131),
b) a gas inlet port (111) for injecting chemical processing gas into the chamber (131),
c) a gas outlet port (112) for evacuation of gases from the chamber (131), and
d) a susceptor support (136) for a substrate (135) to be processed having a substrate support surface (146) and a backside surface (145) opposite to said support surface, said substrate support surface (146) having a pocket (250) therein for the reception of the substrate (135), the pocket (250) having a floor and generally upright sides and being sized to receive the substrate (135) therein, the floor of the pocket having a circumscribing groove (254) dimensioned so that, when the substrate (135) is received in the pocket (250), the groove (254) lies at the perimeter of the substrate (135);
e) characterised in that a preheat ring (140) is provided adjacent to and surrounding said susceptor support, the susceptor support (136) has an extension (142) between the support surface (146) and the backside surface (145), and said preheat ring (140) has an extension (144) that mates with the susceptor support extension (142) forming a barrier to prevent said processing gas from reaching the backside surface of the susceptor (145), said groove (254) in the floor of the pocket (250) providing a receptacle for deposited material to reduce the amount of material that is deposited on the backside of the substrate (135).

2. An apparatus according to claim 1, characterised in that a plurality of external heating lamps (138, 139) heat the preheat ring (140) and the susceptor support (136).

3. An apparatus according to claim 1 or 2,
characterised in that said gas inlet port (111) provides a laminar flow of processing gas sequentially across the preheat ring (140) and the susceptor support surface (146).

4. An apparatus according to claim 1 wherein the susceptor support (136) includes a cavity (360) formed in its underside to reduce the thermal mass of the susceptor.

5. A susceptor for use in a substrate processing apparatus including a substrate processing chamber (131) for housing the susceptor, the susceptor comprising
a) a front, substrate receiving surface (146) and a rear surface (145),
b) a substrate receiving pocket (250) formed in the front surface (146), the pocket (250) having a floor and generally upright sides being sized to receive a substrate (135) therein, and
c) a groove (254) about the periphery and formed into the floor of said pocket (250) and being dimensioned so that, when the substrate (135) is received in the pocket (250), the groove (254) lies at the perimeter of the substrate;
characterised in that a preheat ring (140) is provided adjacent to and surrounding said susceptor support, the susceptor support (136) has an extension (142) between the support surface (146) and the backside surface (145), and said preheat ring (140) has an extension (144) that mates with the susceptor support extension (142) forming a barrier to prevent processing gases from reaching the backside surface of the susceptor (145), said groove (254) in the floor of the pocket (250) providing a receptacle for deposited material to reduce the amount of material that is deposited on the backside of the substrate (135).

6. A susceptor according to claim 5 wherein said susceptor has a cavity (360) in the backside thereof to reduce the mass of the susceptor.

## Patentansprüche

1. Vorrichtung zum chemischen Behandeln eines Substrats mit
a) einem Gehäuse, das eine Substratbehandlungskammer (131) aufweist,
b) einer Gaseinlaßöffnung (111) zum Einblasen von chemischem Behandlungsgas in die Kammer (131),
c) einer Gasauslaßöffnung (112) zum Abführen von Gasen aus der Kammer (131) und
d) einem Suszeptorhalter (136) für ein zu behandelndes Substrat (135), der eine Substrattragfläche (146) und eine der Tragfläche gegenüberliegende rückseitige Fläche (145) aufweist, wobei in der Substrattragfläche (146) eine Tasche (250) für die Aufnahme des Substrats (135) vorgesehen ist, die Tasche (250) einen Boden und insgesamt hochstehende Seiten aufweist und für die Aufnahme des Substrats (135) bemessen ist, und der Boden der Tasche eine umschreibende Nut (254) hat, die so bemessen ist, daß sie, wenn das Substrat (135) in der Tasche (250) aufgenommen ist, am Umfang des Substrats (135) liegt,
e) dadurch gekennzeichnet, daß angrenzend an den Suszeptorhalter und ihn umgebend ein Vorerhitzungsring (140) vorgesehen ist, wobei der Suszeptorhalter (136) zwischen der Tragfläche (146) und der rückseitigen Fläche (145) einen Fortsatz (142) und der Vorerhitzungsring (140) einen Fortsatz (144) hat, der mit dem Suszeptorhalterfortsatz (142) so zusammenpaßt, daß eine Sperre gebildet wird, die verhindert, daß Prozeßgas die rückseitige Fläche des Suszeptors (145) erreicht, und die Nut (254) im Boden der Tasche (250) ein Behältnis für abgeschiedenes Material bereitstellt, um die Menge des Materials zu verringern, das auf der Rückseite des Substrats (135) abgeschieden wird.

2. Vorrichtung nach Anspruch 1, dadurch gekennzeichnet, daß eine Vielzahl von äußeren Heizlampen (138,139) den Vorerhitzungsring (140) und den Suszeptorhalter (136) erhitzen.

3. Vorrichtung nach Anspruch 1 oder 2, dadurch gekennzeichnet, daß die Gaseinlaßöffnung (111) eine laminare Strömung des Behandlungsgases nacheinander über den Vorerhitzungsring (140) und die Suszeptortragfläche (146) erzeugt.

4. Vorrichtung nach Anspruch 1, bei welcher der Suszeptorhalter (136) einen Hohlraum (360) hat, der in seiner Unterseite ausgebildet ist, um die thermische Masse des Suszeptors zu verringern.

5. Suszeptor zur Verwendung in einer Substratbehandlungsvorrichtung mit einer Substratbehandlungskammer (131) zur Aufnahme des Suszeptors, wobei der Suszeptor
a) eine vordere Substrataufnahmefläche (146) und eine hintere Fläche (145),
b) eine Substrataufnahmetasche (250), die in der vorderen Fläche (146) ausgebildet ist und einen Boden und insgesamt hochstehende Seiten hat, die für die Aufnahme eines Substrats (135) darin bemessen sind, und
c) eine Nut (254) um den Umfang aufweist, die im Boden der Tasche (250) ausgebildet und so bemessen ist, daß sie, wenn das Substrat (135) in der Tasche (250) aufgenommen ist, auf dem Umfang des Substrats liegt,
dadurch gekennzeichnet,
- daß angrenzend an den Suszeptorhalter und ihn umschließend ein Vorerhitzungsring (140) vorgesehen ist, wobei
- der Suszeptorhalter (136) einen Fortsatz (142) zwischen der Tragfläche (146) und der rückseitigen Fläche (145) hat,
- der Vorerhitzungsring (140) einen Fortsatz (144) hat, der mit dem Suszeptorhalterfortsatz (142) so zusammenpaßt, daß eine Sperre gebildet wird, die verhindert, daß Behandlungsgas die rückseitige Fläche des Suszeptors (154) erreicht, und
- die Nut (254) in dem Boden der Tasche (250) ein Behältnis für abgeschiedenes Material bereitstellt, um die Menge des Materials zu verringern, das auf der Rückseite des Substrats (135) abgeschieden wird.

6. Suszeptor nach Anspruch 5, bei welchem der Suszeptor einen Hohlraum (360) in seiner Rückseite hat, um die Masse des Suszeptors zu verringern.

## Revendications

1. Appareil de traitement chimique d'un substrat, comprenant :
a) un boîtier possédant une chambre (131) de traitement de substrat,
b) un orifice (111) d'entrée de gaz destiné à injecter un gaz de traitement chimique dans la chambre (131),
c) un orifice (112) de sortie de gaz destiné à l'évacuation des gaz de la chambre (131), et
d) un support convertisseur (136) d'un substrat (135) à traiter, ayant une surface (146) de support de substrat et une surface arrière (145) opposée à la surface de support, la surface (146) de support de substrat ayant une poche (250) pour le logement du substrat (135), la poche (250) ayant un fond et des côtés perpendiculaires de façon générale et ayant une dimension telle qu'ils peuvent loger le substrat (135), le fond de la poche ayant une gorge circonscrite (254) de dimensions telles que, lorsque le substrat (135) est logé dans la poche (250), la gorge (254) se trouve à la périphérie du substrat (135),
e) caractérisé en ce qu'un anneau de préchauffage (140) est placé près du support convertisseur et autour de celui-ci, le support convertisseur (136) a un prolongement (142) placé entre la surface de support (146) et la surface arrière (145), et l'anneau de préchauffage (140) a un prolongement (144) qui coopère avec le prolongement (142) du support convertisseur et formant une barrière destinée à empêcher le gaz de traitement d'atteindre la surface arrière du support convertisseur (145), la gorge (254) du fond de la poche (250) formant un réceptacle pour le dépôt d'un matériau, afin que la quantité d'un matériau déposé à la face arrière du substrat (135) soit réduite.

2. Appareil selon la revendication 1, caractérisé en ce que plusieurs lampes extérieures de chauffage (138, 139) chauffent l'anneau de préchauffage (140) et le support convertisseur (136).

3. Appareil selon la revendication 1 ou 2, caractérisé en ce que l'orifice d'entrée de gaz (111) forme un écoulement laminaire du gaz de traitement successivement sur l'anneau de préchauffage (140) et la surface (146) du support convertisseur.

4. Appareil selon la revendication 1, dans lequel le support convertisseur (136) comporte une cavité (360) formée à la face inférieure pour la réduction de la masse thermique du support convertisseur.

5. Support convertisseur destiné à être utilisé dans un appareil de traitement de substrat comprenant une chambre de traitement de substrat (131) pour le logement du support convertisseur, ce dernier comprenant
a) une surface avant (146) de logement de substrat et une surface arrière (145),
b) une poche (250) de logement de substrat formée à la surface avant (146), la poche (250) ayant un fond et des côtés perpendiculaires de façon générale dont la dimension est telle qu'ils peuvent loger un substrat (135), et
c) une gorge (254) formée à la périphérie et au fond de la poche (250), et ayant des dimensions telles que, lorsque le substrat (135) est logé dans la poche (250), la gorge (254) se trouve à la périphérie du substrat,
caractérisé en ce qu'un anneau de préchauffage (140) est placé près du support convertisseur et entoure celui-ci, le support convertisseur (136) a un prolongement (142) formé entre la surface de support (146) et la surface arrière (145), et l'anneau de préchauffage (140) a un prolongement (144) qui coopère avec le prolongement (142) du support convertisseur formant une barrière pour empêcher les gaz de traitement d'atteindre la surface arrière du support convertisseur (145), la gorge (254) du fond de la poche (250) formant un réceptacle pour la matière déposée afin que la quantité de matière déposée à la face arrière du substrat (135) soit réduite.

6. Support convertisseur selon la revendication 5, dans lequel le support possède une cavité (360) formée à sa face arrière et destinée à réduire la masse du support convertisseur.
